# FASCICULE DE BREVET EUROPEEN

(11) **EP 2 250 510 B1**
(45) Date de publication et mention de la délivrance du brevet: **17.10.2018**
(21) Numéro de dépôt: 09713293.0
(22) Date de dépôt: 17.02.2009
(51) Int. Cl.: G01R 29/08, G01R 31/00

(54) **DISPOSITIF ET PROCEDE POUR LA DETERMINATION D'AU MOINS UNE GRANDEUR ASSOCIEE AU RAYONNEMENT ELECTROMAGNETIQUE D'UN OBJET SOUS TEST**
VORRICHTUNG UND VERFAHREN ZUR BESTIMMUNG VON MINDESTENS EINEM MIT DER ELEKTROMAGNETISCHEN STRAHLUNG EINES GETESTETEN OBJEKTS ASSOZIIERTEN WERT
DEVICE AND METHOD FOR DETERMINING AT LEAST ONE VALUE ASSOCIATED WITH THE ELECTROMAGNETIC RADIATION OF AN OBJECT BEING TESTED

(30) Priorité: 20.02.2008 FR 0851093
(43) Date de publication de la demande: 17.11.2010
(73) Titulaire: Microwave Vision, 91140 Villebon Sur Yvette (FR)
(72) Inventeur: GARREAU, Philippe, F-75011 Paris (FR); IVERSEN, Per, Marietta, 30068 (US); GANDOIS, Arnaud, F-91650 Breuillet (FR); DUCHESNE, Luc, F-91470 Angervilliers (FR)
(74) Mandataire: Regimbeau
(86) Numéro de dépôt international: PCT/EP2009/051861
(87) Numéro de publication internationale: WO 2009/103702

(56) Documents cités:
- FR-A- 2 313 682
- FR-A- 2 858 855
- RU-C1- 2 014 624
- US-A- 5 365 241
- ALTMAN Z ET AL: "Spherical Near Field Facility for Characterizing Random Emissions" IEEE TRANSACTIONS ON ANTENNAS AND PROPAGATION, IEEE SERVICE CENTER, PISCATAWAY, NJ, US, vol. 53, no. 8, 1 août 2005 (2005-08-01), pages 2582-2589, XP011137410 ISSN: 0018-926X

## Description

L'invention concerne des dispositifs et procédés pour la détermination d'au moins une grandeur associée au rayonnement électromagnétique d'un objet sous test.

Il a déjà été proposé, pour déterminer le diagramme de rayonnement d'un objet sous test, d'utiliser des dispositifs qui se présentent sous la forme d'un réseau de sondes réparties sur une arche circulaire, une portion d'arche, une sphère, une portion de sphère (calotte sphérique) ou une portion de cylindre (calotte cylindrique) placé autour de l'objet sous test à étudier ou encore sur une ligne ou un plan placé devant l'objet sous test à étudier.

On connaît ainsi des dispositifs de ce type qui comportent des moyens qui permettent à l'arche de sondes, à la portion d'arche, à la sphère ou à la portion de sphère et à l'objet sous test de tourner l'un par rapport à l'autre autour d'un axe qui correspond à un diamètre de l'arche ou de la sphère de façon à mesurer le rayonnement de l'objet sous test dans des plans successifs répartis autour de l'axe de rotation relatif de l'arche ou de la sphère et de l'objet sous test c'est à dire sur une sphère ou une portion de sphère entourant l'objet.

Il est également connu d'utiliser des réseaux de sondes en arche, portion d'arche ou portion de cylindre en déplaçant de façon relative l'objet sous test perpendiculairement par rapport au plan du réseau de sondes de façon à mesurer ainsi le rayonnement sur un cylindre ou une portion de cylindre entourant l'objet.

Il est aussi connu d'utiliser des réseaux de sondes en ligne en tournant de façon relative l'objet sous test autour d'un axe parallèle au réseau de sonde de façon à mesurer ainsi le rayonnement sur un cylindre entourant l'objet.

Il est aussi connu d'utiliser des réseaux de sondes en ligne ou en plan en déplaçant de façon relative l'objet sous test sur un plan parallèle au réseau de sonde de façon à mesurer ainsi le rayonnement sur un plan devant l'objet.

Ces dispositifs à réseau de sondes en arche, sphère, ligne ou plan présentent toutefois, qu'ils soient utilisés pour des mesures en coordonnées sphériques, des mesures en coordonnées cylindriques ou des mesures en coordonnées cartésiennes des limitations liées au pas de mesure discrétisé imposé par la disposition des sondes en réseau.

En effet, le nombre de points de mesure nécessaire pour mesurer une antenne à une fréquence donnée est lié directement à la taille de la source rayonnante et à la longueur d'onde à la fréquence de mesure (λ). Par exemple, pour des mesures en géométrie sphérique ou cylindrique, différents critères d'échantillonnage existent pour déterminer le nombre de points de mesure nécessaires le long de l'arche, de la portion d'arche, sur la sphère, la portion de sphère ou la portion de cylindre. Le plus connu est donné par la distance minimum égale à λ/2 entre les points d'échantillonnage sur la sphère minimum entourant la source, sphère minimum de diamètre D et dont le centre coïncide avec le centre du réseau. Ce qui correspond à un espacement angulaire entre les sondes de mesure du réseau égal à λ/D. De même pour des mesures en géométrie planaire, le critère d'échantillonnage est donné par la distance minimum égale à λ/2 entre les points d'échantillonnage sur un plan devant la source. Ce qui correspond à un espacement entre les sondes de mesure du réseau égal à λ/2.

L'utilisation d'un réseau de sondes dont la taille, le nombre et l'espacement des sondes de mesure sont physiquement limités impose alors soit, pour une fréquence donnée, des contraintes sur les dimensions de l'objet sous test dont on veut mesurer le champ, soit, pour des dimensions de l'objet sous test données, des contraintes sur la fréquence de mesure maximale possible.

Pour pallier ces inconvénients, on a alors proposé dans le cadre des mesures en géométries sphérique et cylindriques un dispositif comprenant des moyens autorisant le basculement relatif du réseau de sondes et/ou de l'objet sous test pour décaler angulairement l'un par rapport à l'autre le réseau de sondes de l'objet sous test et permettre ainsi des mesures selon plusieurs positions angulaires relatives décalées d'une fraction de pas du réseau de sondes et de l'objet sous test.

De cette façon, on multiplie pour chaque position relative du réseau de sondes et de l'objet sous test le nombre de points de mesure. Par conséquent, pour des dimensions de l'objet à mesurer données, cela permet d'augmenter la fréquence maximale de mesure possible. De même pour une fréquence de mesure donnée, cela permet d'augmenter les dimensions de l'objet sous test dans le cadre de mesures en géométries sphériques et cylindriques.

Un exemple en ce sens est par exemple décrit dans la demande FR 2 858 855 qui prévoit un dispositif selon le préambule de la revendication 1.

Cependant, ce type de dispositif reste toujours peu adapté pour les objets de grandes dimensions dans la mesure où il nécessite des réseaux de sondes et/ou des installations de mesure dont les dimensions doivent être adaptées à celles de ces objets.

D'autre part, il n'offre pas la possibilité de sélectionner spécifiquement les zones géométriques d'un objet sous test où l'on souhaite effectuer des mesures de rayonnement.

On connaît par ailleurs par RU 2 014 624 un système comportant au moins une sonde unique qui se déplace sur un guide en arc de cercle.

Un but de l'invention est de pallier les inconvénients des systèmes antérieurs.

Un autre but de l'invention est d'élargir le domaine d'utilisation d'un réseau de sondes donné notamment en termes de taille d'objet dont on peut déterminer le diagramme de rayonnement tout en conservant une capacité d'échantillonnage illimitée.

Un autre but de l'invention est de proposer un dispositif de mesure mobile, compact et économique capable d'être transporté précisément vers des zones géométriques d'un objet où l'on souhaite effectuer des mesures de rayonnement.

Un dernier but de la présente invention est de proposer un dispositif permettant de mesurer le rayonnement d'objets aux dimensions importantes à des fréquences plus élevées et avec un nombre de sondes réduit.

Ces buts sont atteints selon l'invention grâce à un dispositif pour la détermination d'au moins une caractéristique de rayonnement électromagnétique d'un objet sous test selon la revendication 1. La revendication 2 a pour objet un mode de réalisation de ce dispositif.

L'invention concerne également un procédé pour la détermination d'au moins une caractéristique de rayonnement électromagnétique d'un objet sous test selon la revendication 3.

D'autres caractéristiques, buts et avantages de l'invention apparaîtront à la lecture de la description détaillée qui va suivre, laquelle est purement illustrative et non limitative et doit être lue au regard du dessin annexé sur lequel :
- la figure 1 illustre un dispositif de mesure selon un mode de réalisation de l'invention;
- les figures 2 et 3 illustrent le dispositif de la figure 1 mis en oeuvre pour tester un avion.

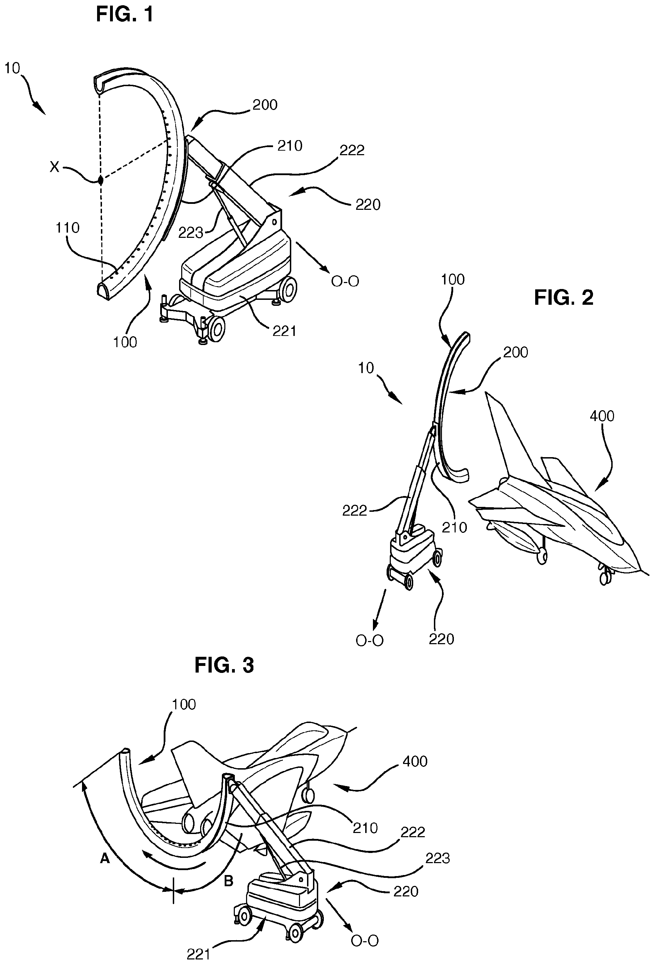

On a représenté sur les figures 1 à 3 un dispositif de mesure 10 conforme à l'invention comprenant principalement un réseau d'antennes de mesure 100 réparties sur une arche 110 montée sur un système de glissement 200 pour déterminer le diagramme de rayonnement d'un objet sous test 400.

Ce dispositif 10 permet de définir un concept d'un oeil ou d'une vision micro-onde pour lequel on apporte le moyen de mesure 100 vers des zones précises de l'objet sous test 400 dont on cherche à connaître le comportement électromagnétique et on mesure des objets sous test 400 de dimensions importantes.

### 1. Arche d'antennes de mesure

Sur les figures 1 à 3, on observe une arche 110 se présentant sous la forme d'un demi-cercle.

Cette arche 110 comporte un réseau de sondes électromagnétiques 100 (ou réseau d'antennes de mesure) représentées schématiquement par des points.

Il est à noter qu'un réseau 100 se définit comme une série de n antennes de mesure, n étant supérieur ou égal à 2.

De préférence, ce réseau 100 combine, sur la même arche 110, deux séries ou plus de sondes électromagnétiques imbriquées ou pas et fonctionnant sur des bandes de fréquences différentes pour élargir la bande de fonctionnement du dispositif de mesure 10.

On peut ainsi citer comme exemple non limitatif un réseau 100 combinant deux séries de sondes électromagnétiques de manière à réaliser des mesures couvrant la bande de fréquence 0.4GHz à 18GHz.

Suivant les variantes de réalisation, le réseau 100 peut comprendre soit une succession de deux séries ou plus de sondes électromagnétiques, soit une alternance régulière ou pas de ces deux séries de sondes électromagnétiques le long de l'arche 110. Les différentes séries de sondes peuvent être considérées comme des sous-réseaux.

### 2. Système de glissement du réseau de sondes électromagnétiques

Il est par ailleurs prévu un système de glissement 200 comportant des moyens 210 destinés à permettre le glissement de l'arche 110 supportant le réseau de sondes électromagnétiques 100 dans le plan du réseau 100 autour de son centre géométrique, centre mis en évidence sur la figure 1 par un une croix.

Ces moyens de glissement 210 sont avantageusement choisis pour décaler angulairement le réseau de sondes 100 de l'objet sous test 400 l'un par rapport à l'autre. Par exemple, l'arche 110 du réseau de sondes électromagnétiques 100 peut se déplacer angulairement en balayant plus d'un demi cercle entourant l'objet sous test 400 comme illustré sur la figure 3.

Ces moyens de glissement 210 sont illustrés sur les figures 1 à 3 par un bras 210 en forme d'arc de cercle destiné à venir se placer dans le plan du réseau 100, autour de l'objet sous test 400.

Ce bras 210 comporte des moyens aptes à recevoir et à fixer dans une position réglable le long de celui ci, l'arche 110 supportant le réseau de sondes électromagnétiques 100.

Ainsi, il présente une surface intérieure concave sur laquelle vient s'appuyer et glisser, par des moyens appropriés comme un film hydraulique, un rouleau à billes ou autres, une surface convexe complémentaire de l'arche 110.

Dans une variante de réalisation, la surface intérieure du bras 210 peut présenter des rainures de guidage pour permettre le glissement de l'arche le long du bras 210 vers la position désirée.

D'autres moyens de glissement sont bien entendu possibles.

De plus, une motorisation électrique, par des moyens appropriés comme un système à crémaillère, un système à vis sans fin, un système à courroie crantée ou autre peut être prévue pour déplacer angulairement l'arche 110 le long du bras 210.

Par ailleurs, le système de glissement 200 présente des moyens 220 lui permettant de déplacer aisément le bras 210 associé à l'arche 110 du réseau de sondes électromagnétiques 100 dans toutes les directions par rapport à l'objet sous test 400.

De préférence, le bras 210 est relié par un mat télescopique 222 à un support 221 monté sur des roues, des rails ou sur coussin d'air pour avoir un dispositif 10 mobile.

Plus précisément, ce mat télescopique 222 peut déplacer grâce à un vérin 223, en s'étendant ou se rétractant, le réseau de sondes électromagnétiques 100 monté sur le bras 210 pour qu'il soit ajusté à une hauteur déterminée. Il possède ainsi plusieurs tronçons d'extension adaptés pour obtenir une course suffisante permettant de placer la zone de l'objet sous test 400 à étudier au centre géométrique du réseau de sondes 110.

Par ailleurs, ce mat 222 peut comprendre des moyens adaptés pour permettre la rotation du bras 210 autour de son axe longitudinal O-O. De plus, des moyens supplémentaires comprenant des rotations et des translations du bras 210 peuvent être mis en oeuvre avant la mesure de façon à placer, ajuster et aligner précisément le dispositif de mesure 10 par rapport à l'objet sous test 400. Durant la séquence de mesure, certains de ces moyens ou d'autres moyens supplémentaires peuvent servir à réaliser un balayage suivant une géométrie sphérique ou cylindrique avec l'arche 110 supportant le réseau de sondes 100 autour des zones particulières à mesurer.

De manière avantageuse, le dispositif de mesure 10 est ainsi mobile et transportable vers l'objet sous test 400 et plus précisément les zones particulières de l'objet sous test 400 où l'on souhaite réaliser l'étude de rayonnement.

### 3. Support de l'objet sous test

Un support (non illustré) pour l'objet sous test 400 peut également être prévu. Ce support peut intégrer des moyens de rotation et de translation pour placer et ajuster l'objet sous test dans la zone de test si nécessaire.

Dans la plupart des cas, ce support n'est pas nécessaire car c'est le système de mesure 10 qui vient à/s'adapte à l'objet sous test 400 et non plus l'objet sous test 400 qui doit s'adapter au moyen de mesure comme ce qui existe conventionnellement dans l'état de l'art de la mesure d'antennes.

### 4. Mouvement mécanique de glissement

Concernant le mouvement mécanique de glissement de l'arche 110 supportant le réseau de sondes électromagnétiques 100 sur le bras 210, celui-ci permet avantageusement de multiplier, dans un plan de mesure de rayonnement, c'est-à-dire pour chaque position relative du bras 210 par rapport à l'objet sous test 400, les points de mesure de rayonnement mais aussi d'agrandir la zone géométrique de mesure de l'objet sous test 400 couverte.

En effet, suite au glissement de l'arche 110 supportant le réseau de sondes électromagnétiques 100 sur le bras 210 d'une position initiale vers une position finale le long du bras 210 comme illustré successivement sur les figures 2 et 3, on peut distinguer deux zones: une zone A où le déplacement de l'arche 110 va permettre d'acquérir des mesures dans une zone géométrique de l'objet sous test 400 différente de celle précédemment soumise à des mesures et une zone B où le déplacement de l'arche 110 va permettre de réaliser un suréchantillonnage des mesures effectuées.

Bien entendu, un suréchantillonnage peut également être réalisé sur la zone A.

Dans la zone B, le mouvement de glissement de l'arche 110 sur le bras 210 permet de décaler angulairement le réseau de sondes électromagnétiques 100 par rapport à l'objet sous test 400 et permet de balayer plusieurs positions relatives du réseau de sondes 100 par rapport à l'objet sous test 400.

Ainsi pour chaque plan de mesure de rayonnement, il est possible d'effectuer plusieurs séries de points de mesure consécutifs correspondant aux différents décalages angulaires relatifs du réseau de sondes 100 par rapport à l'objet sous test 400.

Selon les mouvements de glissement réalisés, ces décalages angulaires relatifs du réseau de sondes électromagnétiques 100 et de l'objet sous test 400 sont supérieurs au pas angulaire du réseau de sondes 100.

Les mouvements de glissement de l'arche 110 dans le plan du réseau 100 permettent donc de multiplier les points de mesures électromagnétiques autour de l'objet sous test 400 et de réaliser avec un réseau de sondes 100 de pas donné, un échantillonnage angulaire accru.

Par ailleurs, dans la zone A, le mouvement de glissement de l'arche 110 supportant le réseau de sondes électromagnétiques 100 sur le bras 210 permet d'effectuer des relevés de points de mesure correspondant à un décalage angulaire relatif du réseau de sondes 100 par rapport à l'objet sous test 400 non encore réalisé lors du ou des précédents positionnements angulaires de l'arche 110 par rapport à l'objet sous test 400.

Le mouvement de glissement de l'arche 110 permet de couvrir, dans un plan de mesure de rayonnement, une zone géométrique de l'objet sous test 400 différente de celle précédemment étudiée avant le glissement de l'arche 110.

Ainsi, les moyens permettant le glissement de l'arche 110 supportant le réseau de sondes électromagnétiques 100 sont aptes à permettre des mesures selon plusieurs positions angulaires relatives du réseau de sondes 100 et de l'objet sous test 400 sur une distance angulaire supérieure à la distance angulaire sur laquelle s'étend le réseau de sondes 100.

Par conséquent, une arche 110 supportant un réseau de sondes électromagnétiques 100 associé à des moyens permettant son glissement trouve un avantage pour les objets de dimensions importantes pour lequel la construction d'une arche et/ou d'une chambre anéchoïque de taille adaptée aux dimensions de l'objet n'est plus nécessaire.

Un autre avantage est de pouvoir avoir accès avec le réseau de sondes 100 à des zones géométriques de l'objet sous test 400 naturellement difficilement accessibles, par exemple sur les figures 2 et 3 la queue, le nez ou sous le fuselage de l'avion.

### 5. Autres géométries

### Réseaux sphériques et cylindriques

Dans une autre variante de réalisation, le réseau de sondes 100 peut être réparti sur un support en forme de calotte sphérique ou cylindrique.

Il est alors prévu un système de glissement 200 comportant des moyens destinés à permettre le glissement de la calotte supportant le réseau de sondes électromagnétiques 100 de façon à permettre des mesures de champs en coordonnées sphériques ou cylindriques.

Ces moyens de glissement 210 peuvent prendre alors la forme de deux bras en forme d'arc de cercle pour la calotte sphérique et d'un bras en forme d'arche de cercle associé à un bras linéaire pour la calotte cylindrique, les deux bras comportant des moyens aptes à recevoir et à fixer dans une position réglable le long de ceux-ci la calotte du réseau de sondes électromagnétiques 100.

Ces deux bras étant disposés d'une façon à permettre deux déplacements perpendiculaires de la calotte du réseau de sondes électromagnétiques 100 pour réaliser des mesures de champs sur une sphère ou un cylindre entourant l'objet 400.

En conclusion, l'homme de l'art appréciera un dispositif de mesure 10 permettant une multiplication des points de mesures effectués par rapport au réseau de sondes 100 utilisé mais également une plus grande zone géométrique de mesure de l'objet sous test 400 étudiée par rapport au réseau de sondes 100 utilisé et, par conséquent, l'opportunité de pouvoir déterminer le diagramme de rayonnement d'objets sous tests 400 sans contraintes sur leurs dimensions, et aussi de pouvoir accéder durant les mesures avec le réseau de sondes 100 à des zones géométriques particulières de l'objet sous test et parfois naturellement difficilement accessibles.

De plus un ensemble de moyens de rotations et de translations du bras 210 permet de positionner, d'ajuster et d'aligner le dispositif de mesure 10 par rapport à l'objet sous test 400. Durant la séquence de mesure, certains de ces moyens ou d'autres moyens supplémentaires peuvent servir à réaliser un balayage suivant une géométrie sphérique, cylindrique ou planaire avec l'arche 110 supportant le réseau de sondes 100 devant ou autour des zones particulières à mesurer.

Les caractéristiques du moyen de mesure 10 décrites ci-dessus correspondent au concept « de l'oeil micro-onde » permettant au moyen de mesure 10 d'aller vers / venir à / s'adapter à l'objet sous test 400.

## Revendications

1. Dispositif (10) pour la détermination d'au moins une caractéristique de rayonnement électromagnétique d'un objet sous test (400), le dispositif comportant un réseau d'antennes (100) de mesure de rayonnement réparties selon un pas angulaire donné entre les antennes,
**caractérisé en ce que** les antennes (100) de mesure de rayonnement sont réparties sur une arche (110) en forme d'arc de cercle montée sur un bras (210) en forme d'arc de cercle placé dans un plan du réseau,
le dispositif comportant des moyens permettant le glissement (200) de l'arche (110) sur le bras (210) pour effectuer des relevés de points de mesure de rayonnement sur une première distance angulaire supérieure à une deuxième distance angulaire sur laquelle s'étend le réseau d'antennes (100), avec un décalage relatif du réseau d'antennes (100) et de l'objet sous test (400) supérieur au pas du réseau d'antennes (100) pour effectuer des mesures selon plusieurs positions relatives du réseau d'antennes (100) et de l'objet sous test (400).

2. Dispositif selon la revendication 1, **caractérisé en ce que** les moyens permettant le glissement (200) du réseau d'antennes (100) sont fixés à un mat télescopique (222) relié à un support monté sur roues, sur rails ou sur coussins d'air permettant d'obtenir un dispositif mobile.

3. Procédé pour la détermination d'au moins une caractéristique de rayonnement électromagnétique d'un objet sous test (400) au moyen d'un dispositif (10) comportant un réseau d'antennes (100) de mesure de rayonnement réparties selon un pas angulaire donné entre les antennes,
**caractérisé en ce que** les antennes (100) de mesure de rayonnement sont réparties sur une arche (110) en forme d'arc de cercle montée sur un bras (210) en forme d'arc de cercle placé dans un plan du réseau,
le procédé comprenant au moins une étape de glissement de l'arche (110) sur le bras (210) pour effectuer des relevés de points de mesure de rayonnement sur une première distance angulaire supérieure à une deuxième distance angulaire sur laquelle s'étend le réseau d'antennes (100), avec un décalage relatif du réseau d'antennes (100) et de l'objet sous test (400) supérieur au pas du réseau d'antennes (100) pour effectuer des mesures selon plusieurs positions relatives du réseau d'antennes (100) et de l'objet sous test (400).

## Patentansprüche

1. Vorrichtung (10) zur Bestimmung mindestens eines Merkmals einer elektromagnetischen Strahlung eines getesteten Objekts (400), wobei die Vorrichtung ein Netzwerk von Strahlungsmessungs-Antennen (100) aufweist, die gemäß einem bestimmten Winkelschritt zwischen den Antennen verteilt sind,
**dadurch gekennzeichnet, dass** die Strahlungsmessungs-Antennen (100) auf einem kreisbogenförmigen Bogen (110) verteilt sind, der auf einem kreisbogenförmigem Arm (210) angebracht ist, der in einer Ebene des Netzwerks platziert ist,
wobei die Vorrichtung Mittel aufweist, welche das Gleiten (200) des Bogens (110) auf dem Arm (210) erlaubt, um Aufstellungen von Strahlungsmesspunkten über einen ersten Winkelabstand durchzuführen, der größer als ein zweiter Winkelabstand ist, über den sich das Netzwerk von Antennen (100) erstreckt, mit einer relativen Abweichung des Netzwerks von Antennen (100) und des getesteten Objekts (400), der größer als der Schritt des Netzwerks von Antennen (100) für die Durchführung von Messungen gemäß mehreren relativen Positionen des Netzwerks von Antennen (100) und des getesteten Objekts (400) ist.

2. Vorrichtung nach Anspruch 1, **dadurch gekennzeichnet, dass** die Mittel, die das Gleiten (200) des Netzwerks von Antennen (100) erlauben, auf einem Teleskopmast (222) befestigt sind, der mit einem auf Rädern, Schienen oder Luftkissen angebrachten Halter verbunden ist, was erlaubt, eine bewegliche Vorrichtung zu erhalten.

3. Verfahren zur Bestimmung mindestens eines Merkmals einer elektromagnetischen Strahlung eines getesteten Objekts (400) mittels einer Vorrichtung (10), die ein Netzwerk von Strahlungsmessungs-Antennen (100) aufweist, die gemäß einem bestimmten Winkelschritt zwischen den Antennen verteilt sind,
**dadurch gekennzeichnet, dass** die Strahlungsmessungs-Antennen (100) auf einem kreisbogenförmigen Bogen (110) verteilt sind, der auf einem kreisbogenförmigem Arm (210) angebracht ist, der in einer Ebene des Netzwerks platziert ist,
wobei das Verfahren mindestens einen Schritt des Gleitens des Bogens (110) auf dem Arm (210) umfasst, um Aufstellungen von Strahlungsmesspunkten über einen ersten Winkelabstand durchzuführen, der größer als ein zweiter Winkelabstand ist, über den sich das Netzwerk von Antennen (100) erstreckt, mit einer relativen Abweichung des Netzwerks von Antennen (100) und des getesteten Objekts (400), der größer als der Schritt des Netzwerks von Antennen (100) für die Durchführung von Messungen gemäß mehreren relativen Positionen des Netzwerks von Antennen (100) und des getesteten Objekts (400) ist.

## Claims

1. A device (10) for determining at least one characteristic of the electromagnetic radiation of an object (400) being tested, the device comprising a network of radiation-measuring antennae (100) distributed with a given angular pitch between the antennae,
**characterized in that** the radiation-measuring antennae (100) are distributed over an arch (110) in the form of an arc of circle mounted on an arm (210) in the form of an arc of circle placed in a plane of the network,
the device comprising means allowing sliding (200) of the arch (110) on the arm (210) to carry out mapping of radiation-measuring points over a first angular distance that is greater than a second angular distance over which the network of antenna (100) extends, with a relative offset of the network of antennae (100) relatively to the object (400) being tested, which is higher than the pitch of the network of antennae (100) to carry out measurements according to several relative positions of the network of antennae (100) and of the object (400) being tested.

2. The device according to claim 1, **characterized in that** the means allowing sliding (200) of the network of antennae (100) are fixed to a telescopic mast (222) connected to a support mounted on wheels, on rails or on air cushions, resulting in a mobile device.

3. A method for determining at least one characteristic of electromagnetic radiation of an object (400) being tested using a device (10) comprising a network of radiation-measuring antennae (100) distributed with a given angular pitch between the antennae,
**characterized in that** the radiation-measuring antennae (100) are distributed over an arch (110) in the form of an arc of circle mounted on an arm (210) in the form of an arc of circle placed in a plane of the network,
the method comprising at least one sliding step of the arch (110) on the arm (210) to carry out mapping of radiation-measuring points over a first angular distance that is greater than a second angular distance over which the network of antenna (100) extends, with a relative offset of the network of antennae (100) relatively to the object (400) being tested, which is higher than the pitch of the network of antennae (100) to carry out measurements according to several relative positions of the network of antennae (100) and of the object (400) being tested.
